# EUROPÄISCHE PATENTSCHRIFT

(11) **EP 3 688 874 B1**
(45) Veröffentlichungstag und Bekanntmachung des Hinweises auf die Patenterteilung: **19.03.2025**
(21) Anmeldenummer: 18783559.0
(22) Anmeldetag: 21.09.2018
(51) Int. Cl.: H03M 1/10, H03M 1/12

(54) **SCHALTKREIS ZUR ÜBERPRÜFUNG EINER ANALOGEN EINGANGSSCHALTUNG EINES A/D-WANDLERS**
SWITCHING CIRCUIT FOR CHECKING AN ANALOG INPUT CIRCUIT OF AN A-D CONVERTER
CIRCUIT DE VÉRIFICATION D'UN CIRCUIT D'ENTRÉE ANALOGIQUE D'UN CONVERTISSEUR ANALOGIQUE-NUMÉRIQUE

(30) Priorität: 29.09.2017 DE 102017009088
(43) Veröffentlichungstag der Anmeldung: 05.08.2020
(73) Patentinhaber: WAGO Verwaltungsgesellschaft mit beschränkter Haftung, 32423 Minden (DE)
(72) Erfinder: BÜLOW, Alexander, 31655 Stadthagen (DE); VOSS, Christian, 32427 Minden (DE)
(74) Vertreter: Koplin, Moritz
(86) Internationale Anmeldenummer: PCT/IB2018/001083
(87) Internationale Veröffentlichungsnummer: WO 2019/064059

(56) Entgegenhaltungen:
- DE-A1- 10 320 717
- DE-A1- 102008 027 591
- DE-A1- 19 631 972

## Beschreibung

### GEBIET

Die vorliegende Erfindung bezieht sich auf einen Schaltkreis zur Überprüfung einer analogen Eingangsschaltung eines A/D-Wandlers.

### HINTERGRUND

Fehlersichere Eingabe/Ausgabe-Module (F-E/A-Module), die in die Kategorie 4 der DIN EN ISO 13849 fallen, bzw. über eine Risikominderung gemäß DIN EN 61508 und DIN EN 61511 verfügen, weisen typischerweise redundante Übertragungskanäle auf. Daher sind die Ein- und Ausgänge sowie die Mikrocontroller in solchen F-E/A-Modulen oftmals doppelt ausgeführt, wobei fehlerhafte Übertragungskanäle modulseitig durch Überprüfungsschaltungen und über einen Abgleich der über die Übertragungskanäle übertragenen Signale erkannt werden können.

Fehlersichere Analogeingänge sind dabei auf das fehlersichere Erfassen analoger Eingangsgrößen gerichtet, wobei typischerweise jede Eingangsgröße analog vorverarbeitet und die entstehende Spannung, die bspw. proportional zur Eingangsgröße sein kann, im Anschluss digitalisiert und an einen Mikroprozessor weitergeleitet wird. Der Mikroprozessor kann dann die weitere Verarbeitung, wie z. B. die Anwendung von Kalibrierungsdaten auf die digitalisierte Eingangsgröße, durchführen und einen Prozesswert erzeugen, welcher wiederum an eine übergeordnete Steuerung übertragen wird. Die Steuerung kann den Prozesswert anschließend für die Steuerung eines anwendungsspezifischen Prozesses verwenden.

Dabei kann es erforderlich sein, dass ein definierter Prozesswert selbst dann an die Steuerung übergeben wird, wenn die Funktion eines Analogeingangs nicht mehr erfüllt wird. Um das gewährleisten zu können, kann es jedoch nötig sein, die Funktion der Komponenten des fehlersicheren E/A-Moduls während des Betriebs zu überwachen, so dass das E/A-Modul im Falle einer Funktionsstörung einen definierten Zustand einnehmen kann.

Aus der US 5,412,385 A ist eine A/D-Wandler-Einrichtung mit Fehlerkorrektur bekannt. Dabei wird ein analoges Eingangssignal mittels eines A/D-Wandlers gewandelt und das resultierende Digitalsignal mittels eines D/A-Wandlers in ein Analogsignal gewandelt, welches von dem analogen Eingangssignal abgezogen wird. Das Differenzsignal wird dann verstärkt, erneut gewandelt und dazu verwendet, die Genauigkeit des durch den A/D-Wandler erzeugten Digitalsignals zu verbessern.

Aus der DE 103 20 717 A1 ist eine Schaltungsanordnung und ein Verfahren zur Plausibilisierung der ordnungsgemäßen Funktion eines für sicherheitsrelevante Anwendungen ausgelegten A/D-Wandlers bekannt. Eingesetzt werden ein A/D-Wandler, der aus einem analogen Eingangssignal ein digitales Signal bereitstellt, eine Steuereinheit, die aus dem analogen Eingangssignal ein Referenzsignal bereitstellt, eine einen Komparator aufweisende Vergleichseinheit, die das analoge Eingangssignal mit dem Referenzsignal vergleicht und abhängig davon ein Vergleichssignal ausgibt, eine Auswerteeinheit, die durch Vergleich des digitalen Signals und des Vergleichssignals ein Differenzsignal ermittelt und die im Falle, dass das Differenzsignal einen vorgegebenen Schwellenwert überschreitet, ein Fehlersignal ausgibt.

Aus der US 8 947 276 B1 ist ein Verfahren zum Testen von A/D-Wandlern bekannt. Dabei wird ein gewandeltes Signal mit einem Referenzsignal verglichen und die Abweichung der Signale analysiert.

Aus der DE 10 2010 029 497 A1 ist ein Verfahren zum Erkennen von Fehlern eines A/D-Wandlers bekannt, der zur Umwandlung eines analogen Eingangssignals in ein digitales Ausgangssignal ausgebildet ist, wobei vorgesehen ist, dass das digitale Ausgangssignal eine Zahl z repräsentiert, die bei einer vorgenommenen A/D-Wandlung aus einem Eingangswert Uin des analogen Eingangssignals hervorgeht, wobei bei dem Verfahren ein Wertebereich für alle möglichen Zahlen z in Unterbereiche und ein Wertebereich für alle möglichen Eingangswerte Uin in Unterbereiche aufgeteilt wird und ein Eingangswert Uin und eine dazu korrespondierende Zahl z jeweils einander korrespondierenden Unterbereichen zugeordnet werden. Bei dem Verfahren wird überprüft, welchem Unterbereich ein zu wandelnder Eingangswert Uin zugeordnet ist, und welchem Unterbereich eine durch den A/D-Wandler ermittelte Zahl z zugeordnet ist, wobei ein Fehler erkannt wird, wenn die Zahl z und der Eingangswert Uin Unterbereichen, die nicht zueinander korrespondieren, zugeordnet sind.

In einer aus der DE 10 2008 027591 A1 bekannten Fahrzeugelektroniksteuerung erzeugt eine Konstantspannungs-Energieversorgung eine Ausgangsspannung Vad von 5V geringer Kapazität, eine Niederpräzisions-Ausgangsspannung Vif von 0V großer Kapazität und eine Niederpräzisions-Ausgangsspannung Vcp von 3,3V hoher Kapazität und mindestens eine von einer Ausgangsspannung Vup von 2,8V geringer Präzision und geringer Kapazität und einer Hochpräzisions-Ausgangsspannung Vsb von 3,3V hoher Präzision. Eine Beurteilungssignal-Eingangsschaltung kombiniert logisch Vergleichsergebnisse von geteilten Spannungen der obigen Ausgangsspannungen Vif, Vcp, Vup und Vsb mit einer geteilten Spannung der Ausgangsspannung Vad als einer Referenzspannung, und gibt Relativspannungsinformation ER2, ER3, ER4 und ER5 in einen Mikroprozessor ein. Der Mikroprozessor beurteilt die Ausgangsspannungen, die die Vergleichsreferenzspannung enthalten, und meldet eine Abnormalität.

### ZUSAMMENFASSUNG

Die Erfindung bereichert diesbezüglich den Stand der Technik, als ein erfindungsgemäßer Schaltkreis eingerichtet ist, zur Überprüfung einer analogen Eingangsschaltung eines A/D-Wandlers aus einer analogen Eingangsgröße zwei Signale abzuleiten und beide Signale räumlich voneinander getrennt zu verarbeiten, so dass sie in Hinblick auf Störungen (wie z. B. Potentialunterschiede oder EMV-Störungen) und in Hinblick auf durch fehlerhafte Elemente ausgelöste Verarbeitungsfehler voneinander unabhängig sind. Im Anschluss an die Vorverarbeitung können beide Signale dann zur Überprüfung der Vorverarbeitung gegeneinander abgeglichen werden.

Ein erfindungsgemäßer Schaltkreis zur Überprüfung einer analogen Eingangsschaltung eines A/D-Wandlers umfasst dazu die analoge Eingangsschaltung und eine Vergleichsschaltung, wobei die analoge Eingangsschaltung eingerichtet ist, aus einem analogen Eingangssignal der analogen Eingangsschaltung ein erstes abgeleitetes Signal und ein zweites abgeleitetes Signal zu erzeugen, nur das erste abgeleitete Signal ein Eingangssignal für den A/D-Wandler ist, welcher das erste abgeleitete Signal digitalisiert, das erste abgeleitete Signal und das zweite abgeleitete Signal Eingangssignale für die Vergleichsschaltung sind, die Vergleichsschaltung eingerichtet ist, zu überprüfen, ob eine Abweichung der abgeleiteten Signale voneinander innerhalb eines Toleranzbereichs liegt und ein von der Überprüfung abhängiges Ausgangssignal auszugeben, das weiter auswertbar ist.

Dabei ist unter den Begriffen "Schaltkreis" und "Schaltung", wie sie in der Beschreibung und den Ansprüchen verwendet werden, insbesondere ein Zusammenschluss von elektrischen und/oder elektronischen Bauelementen zu einer funktionsgerechten Anordnung zu verstehen. Ferner kann der Vergleich in der Vergleichsschaltung Hardware- oder Software-basiert sowie auf Basis analoger oder digitaler Signale erfolgen. Bspw. kann der Vergleich mittels eines Komparators oder eines Mikrocontrollers erfolgen und der Mikrocontroller oder ein dem Mikrocontroller vorgeschalteter Analog-Digital-Wandler das erste abgeleitete Signal und das zweite abgeleitete Signal vor dem Vergleich digitalisieren. Zudem kann die Überprüfung, ob die Abweichung der abgeleiteten Signale voneinander innerhalb eines Toleranzbereichs liegt durch Differenzbildung aber auch durch andere mathematische Operationen, wie etwa eine Summenbildung, prozentuale Aufteilung o.ä., erfolgen, die einen Abgleich der abgeleiteten Signale zulassen.

Zudem ist unter dem Begriff "Signal", wie er in der Beschreibung und den Ansprüchen verwendet wird, insbesondere ein elektrisches Signal, bspw. eine Spannung, ein definierter Spannungsbereich oder ein bestimmter Spannungsverlauf, zu verstehen. Ferner ist unter dem Begriff "abgeleitetes Signal", wie er in der Beschreibung und den Ansprüchen verwendet wird, insbesondere ein Signal zu verstehen, welches sich mittels einer Rechenvorschrift (bspw. einer stetigen Funktion) aus dem Signal, von dem es abgeleitet ist, berechnen lässt.

Vorzugsweise weist der Schaltkreis ein Schaltelement auf, wobei durch Schließen oder Öffnen des Schaltelements das zweite Signal gezielt verändert oder abgeschaltet werden kann, um einen definierten Fehlerzustand zu erzeugen.

Dabei ist unter dem Begriff "Schaltelement", wie er in der Beschreibung und den Ansprüchen verwendet wird, insbesondere ein Bauelement zu verstehen, welches eingerichtet ist, eine elektrische Verbindung, über die ein Signal übertragen werden kann oder wird, zu unterbrechen (bspw. ein Transistor). Ferner ist unter dem Begriff "Fehlerzustand", wie er in der Beschreibung und den Ansprüchen verwendet wird, insbesondere ein Zustand zu verstehen, der, wenn er nicht aktiv erzeugt wird, eine Fehlfunktion der Schaltung bzw. eine Fehlfunktion von Schaltungselementen nahelegt. Des Weiteren ist unter dem Begriff "definierter Fehlerzustand", wie er in der Beschreibung und den Ansprüchen verwendet wird, insbesondere ein Zustand zu verstehen, der sich aktiv erzeugen lässt und erlaubt zu überprüfen, ob der eine Fehlfunktion nahelegende Zustand erkannt wird.

Vorzugsweise ist die Vergleichsschaltung eingerichtet, aus dem ersten abgeleiteten Signal und dem zweiten abgeleiteten Signal ein Differenzsignal abzuleiten, wobei der Toleranzbereich einen Wertebereich für das Differenzsignal vorgibt.

Dabei ist unter dem Begriff "Differenzsignal", wie er in der Beschreibung und den Ansprüchen verwendet wird, insbesondere eine Spannungsdifferenz zu verstehen.

Vorzugsweise ist die analoge Eingangsschaltung eingerichtet, das erste abgeleitete Signal aus einem Spannungsabfall an einem ersten Widerstand abzuleiten und das zweite abgeleitete Signal aus einem Spannungsabfall an einem zweiten Widerstand abzuleiten, wobei der erste Widerstand und der zweite Widerstand in Reihe an einem Analogeingang der Eingangsschaltung angeschlossen sind.

Vorzugsweise umfasst die analoge Eingangsschaltung einen ersten Verstärker und einen zweiten Verstärker, ist das erste abgeleitete Signal ein Ausgangssignal des ersten Verstärkers und ist das zweite abgeleitete Signal ein Ausgangssignal des zweiten Verstärkers.

Vorzugsweise umfasst ein System zwei der besagten Schaltkreise, einen ersten Schaltkreis und einen zweiten Schaltkreis, wobei der erste Schaltkreis eine erste Selektionsschaltung umfasst und der zweite Schaltkreis eine zweite Selektionsschaltung umfasst, wobei die erste Selektionsschaltung eingerichtet ist, das erste abgeleitete Signal des ersten Schaltkreises oder das erste abgeleitete Signal des zweiten Schaltkreises an den A/D-Wandler des ersten Schaltkreises zu übertragen, wobei die zweite Selektionsschaltung eingerichtet ist, das erste abgeleitete Signal des ersten Schaltkreises oder das erste abgeleitete Signal des zweiten Schaltkreises an den A/D-Wandler des zweiten Schaltkreises zu übertragen, wobei das System ferner eingerichtet ist, zu überprüfen, ob die durch die A/D-Wandler digitalisierten Signale identisch sind oder eine Abweichung der digitalisierten Signale voneinander innerhalb eines Akzeptanzbereichs liegt, wenn die Selektionsschaltungen das erste abgeleitete Signal des ersten Schaltkreises bzw. das erste abgeleitete Signal des zweiten Schaltkreises an die A/D-Wandler übertragen.

Ein erfindungsgemäßes Verfahren zum Digitalisieren eines an einem Analogeingang empfangenen Signals umfasst ein Ableiten eines ersten Signals von dem am Analogeingang empfangenen Signal, ein Ableiten eines zweiten Signals von dem am Analogeingang empfangenen Signal, ein Verstärken des ersten Signals, ein Verstärken des zweiten Signals, ein Digitalisieren des verstärkten ersten Signals, ein Überprüfen, ob eine aus der Ableitung des ersten Signals und der Ableitung des zweiten Signals aus dem empfangenen Signal resultierende erwartete Abhängigkeit der verstärkten Signale, unter Berücksichtigung eines Toleranzbereiches, vorliegt und, wenn die Abhängigkeit der verstärkten Signale nicht vorliegt, ein Erzeugen eines Fehlersignals.

Dabei ist unter dem Begriff "Fehlersignal", wie er in der Beschreibung und den Ansprüchen verwendet wird, insbesondere ein elektrisches Signal (bspw. ein zweiwertiges Signal) zu verstehen, welches einen Fehler signalisiert und entweder zur Anzeige des Fehlers führt oder eine Routine zum Überwinden des Fehlers auslöst.

Vorzugsweise umfasst das Verfahren ferner ein Verstärken eines dritten Signals, welches von dem am Analogeingang empfangenen Signal unabhängig ist oder mittels einer gezielten Modifikation der Ableitung des zweiten Signals erzeugt wird und ein Überprüfen, ob eine Abweichung zwischen dem verstärkten ersten Signal und dem verstärkten dritten Signal außerhalb des Toleranzbereichs liegt.

Vorzugsweise umfasst das Verfahren ferner ein Erzeugen des Fehlersignals, wenn die Abweichung zwischen dem verstärkten ersten Signal und dem verstärkten dritten Signal innerhalb des Toleranzbereichs liegt.

Vorzugsweise umfasst das Verfahren ferner ein Ableiten eines Differenzsignals aus dem verstärkten ersten Signal und dem verstärkten zweiten Signal, wobei der Toleranzbereich einen Wertebereich für das Differenzsignal vorgibt.

### KURZBESCHREIBUNG DER ZEICHNUNGEN

Die Erfindung wird nachfolgend in der detaillierten Beschreibung anhand von Ausführungsbeispielen erläutert, wobei auf Zeichnungen Bezug genommen wird, in denen:
Fig. 1 eine beispielhafte Schaltung mit einem Schaltkreis zur Überprüfung einer analogen Eingangsschaltung eines A/D-Wandlers;
Fig. 1a beispielhafte Spannungsverläufe in der in Fig. 1 gezeigten Schaltung;
Fig. 2 eine Abwandlung des in Fig. 1 gezeigten Schaltkreises zur Erzeugung eines definierten Fehlerzustandes;
Fig. 3 eine mögliche Ausgestaltung der analogen Eingangsschaltung des in Fig. 1 gezeigten Schaltkreises;
Fig. 4 eine weitere mögliche Ausgestaltung der analogen Eingangsschaltung des in Fig. 1 gezeigten Schaltkreises;
Fig. 5 eine weitere mögliche Ausgestaltung der analogen Eingangsschaltung des in Fig. 1 gezeigten Schaltkreises;
Fig. 6 eine weitere mögliche Ausgestaltung der analogen Eingangsschaltung des in Fig. 1 gezeigten Schaltkreises;
Fig. 7 eine weitere mögliche Ausgestaltung der analogen Eingangsschaltung des in Fig. 1 gezeigten Schaltkreises;
Fig. 8 eine mögliche Ausgestaltung des in Fig. 1 gezeigten Schaltkreises;
Fig. 9 eine mögliche Ausgestaltung des in Fig. 2 gezeigten Schaltkreises;
Fig. 10 eine Modifikation der in Fig. 9 gezeigten Ausgestaltung;
Fig. 11 ein System mit zwei der in Fig. 1 gezeigten Schaltungen und zusätzlichen Selektionsschaltungen zur Überprüfung der A/D-Wandler; und
Fig. 12 ein Flussdiagramm eines Prozesses zum Digitalisieren eines an einem Analogeingang empfangenen Signals zeigt.

Dabei sind in den Zeichnungen gleiche oder funktional ähnliche Elemente durch gleiche Bezugszeichen gekennzeichnet.

### DETAILLIERTE BESCHREIBUNG

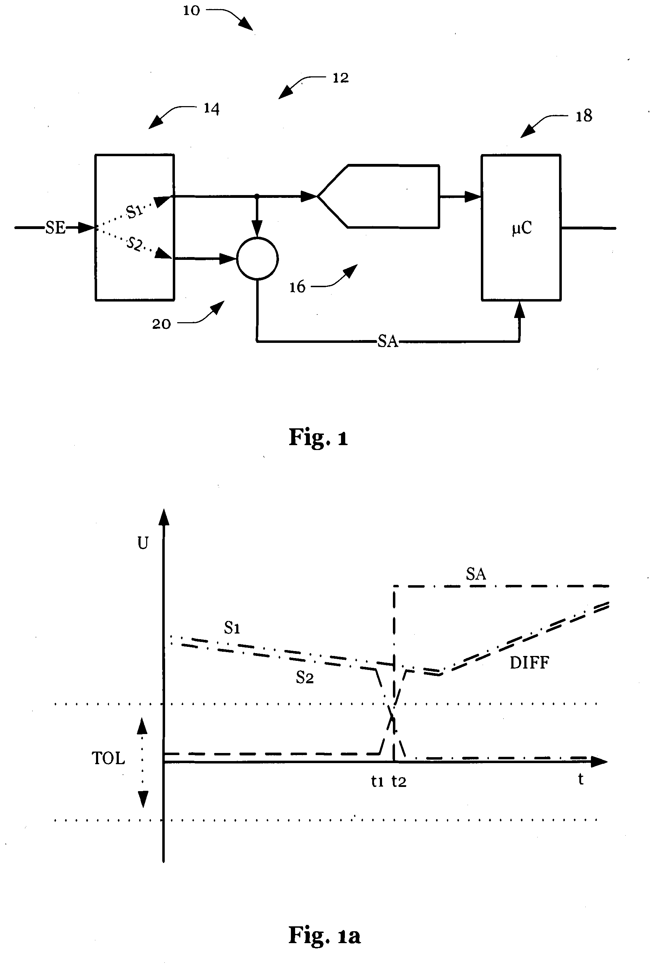

Fig. 1 zeigt eine Schaltung 10 mit einem Schaltkreis 12 zur Überprüfung einer analogen Eingangsschaltung 14 eines Analog/Digital-Wandlers 16 (A/D-Wandlers), welche in einem fehlersicheren E/A-Modul zur Steuerung eines Prozesses oder einer Anlage vorgesehen sein kann. Wie in Fig. 1 gezeigt, leitet die analoge Eingangsschaltung 14 aus dem Eingangssignal SE ein erstes Signal S1 und ein zweites Signal S2 ab. Das erste Signal S1 wird durch den A/D-Wandler 16 digitalisiert und von einem Mikrocontroller 18 eingelesen.

Zur Überprüfung der analogen Eingangsschaltung 14 werden das erste Signal S1 und das zweite Signal S2 durch eine Vergleichsschaltung 20 verarbeitet, die überwacht, ob eine Abweichung der abgeleiteten Signale S1, S2 voneinander innerhalb eines Toleranzbereichs TOL liegt. Auf Basis des Ergebnisses der Überprüfung kann ein Ausgangssignal SA erzeugt werden, das bspw. durch den Mikrocontroller 18 oder eine übergeordnete Steuerung (nicht gezeigt) weiter auswertbar ist.

Fig. 1a zeigt dazu beispielhafte Verläufe der die Signale repräsentierenden Spannungen. Dabei sind die das erste Signal S1 und die das zweite Signal S2 repräsentierenden Spannungen bis zum Zeitpunkt t1 annähernd gleich groß, so dass die Differenzspannung DIFF anfangs innerhalb des (durch die gepunkteten Linien begrenzten) Toleranzbereichs TOL liegt. Ab dem Zeitpunkt t1 verläuft die das zweite Signal S2 repräsentierende Spannung nicht mehr parallel zu der das erste Signal S1 repräsentierenden Spannung. Dadurch liegt die Differenzspannung DIFF ab dem Zeitpunkt t2 außerhalb des Toleranzbereichs TOL. Da die Differenzspannung DIFF ab dem Zeitpunkt t2 außerhalb des Toleranzbereichs TOL liegt, ändert sich der Pegel des Ausgangssignals SA (bspw. wie in Fig. 1a von "Low" nach "High" oder alternativ von "High" nach "Low").

Das Ausgangssignal SA kann vom Mikrocontroller 18 abgetastet werden, der auf Basis der Abweichung der Signale S1, S2 voneinander (d. h. wenn die Differenzspannung DIFF außerhalb des Toleranzbereichs TOL liegt) auf einen Defekt oder eine Störung der analogen Eingangsschaltung 14 schließt. Das den Defekt oder die Störung anzeigende Ausgangssignal SA kann dann eine Verarbeitungsroutine im Mikrocontroller 18 anstoßen und bewirken, dass ein Fehlersignal SF an einem Ausgang des Mikrocontrollers 18 (bspw. über einen Bus) ausgegeben wird.

Z. B. kann der Mikrocontroller 18 in einen vorbestimmten (sicheren) Betriebszustand wechseln bzw. einen durch den Mikrocontroller 18 gesteuerten Prozess oder eine von durch den Mikrocontroller 18 gesteuerte Anlage in einen (sicheren) stabilen Zustand bringen. Dabei versteht es sich, dass die Prüfung, ob die Abweichung der abgeleiteten Signale S1, S2 voneinander innerhalb des Toleranzbereichs TOL liegt, auch durch den Mikrocontrollers 18 erfolgen kann, wenn die Vergleichsschaltung 20 bspw. anstatt des Ausgangssignals SA die Differenzspannung DIFF ausgibt oder der Mikrocontroller 18 (als Teil der Vergleichsschaltung 20) das erste Signal S1 und das zweite Signal S2 (bzw. ein digitalisiertes erstes Signal und ein digitalisiertes zweites Signal) einliest und Software-basiert vergleicht.

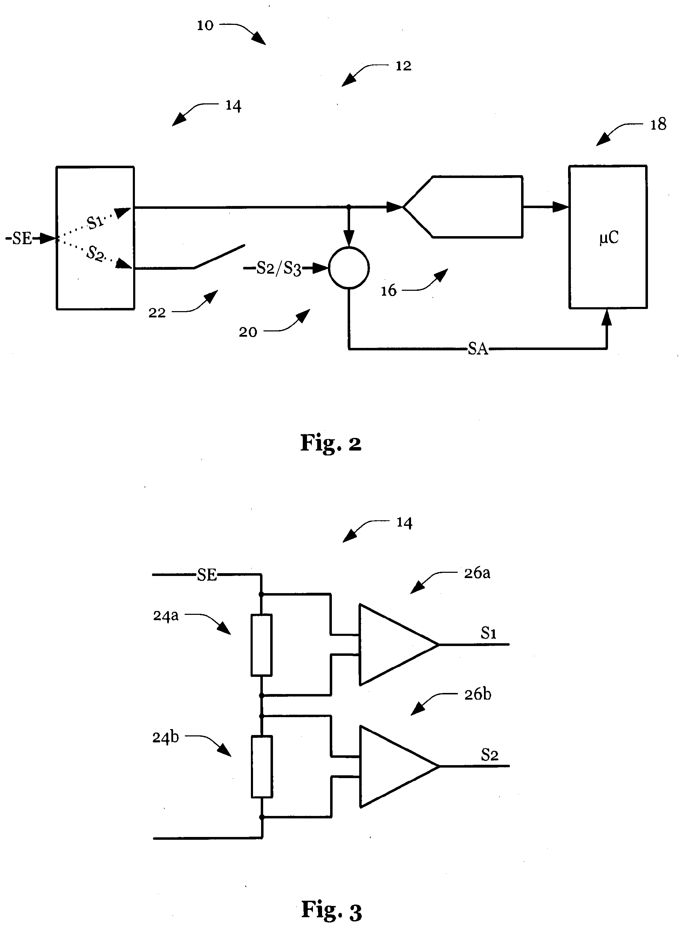

Fig. 2 zeigt eine Abwandlung des in Fig. 1 gezeigten Schaltkreises 12 zur Erzeugung eines definierten Fehlerzustands. Dazu ist der Signalpfad, über den das zweite Signal S2 an die Vergleichsschaltung 20 übertragen wird, mit einem Schaltelement 22 (z. B. einem Halbleiterschalter wie bspw. einem Transistor) versehen, der es erlaubt, die Übertragung des zweiten Signals S2 an die Vergleichsschaltung 20 zu unterbrechen. Dies ermöglicht es, den in Fig. 1a gezeigten Fall (durch eine gezielte Ansteuerung des Schaltelements 22) herbeizuführen.

Dabei wird durch Öffnen des Schaltelements 22 anstatt des zweiten Signals S2 ein drittes Signal S3, welches von dem Eingangssignal SE unabhängig ist (bspw. eine konstante Spannung, die außerhalb des Wertebereichs liegt, der für die das zweite Signal 2 repräsentierende Spannung erwartet wird), an die Vergleichsschaltung 20 übertragen und die Vergleichsschaltung 20 bzw. die Fehlererkennung durch den Mikrocontroller 18 überprüft. Natürlich versteht es sich, dass anstatt des Unterbrechens der Übertragung des zweiten Signals S2 an die Vergleichsschaltung 20 auch eine gezielte Modifikation der Ableitung des zweiten Signal S2 erfolgen kann, so dass das dritte Signal S3 zwar nicht unabhängig vom Eingangssignal SE ist, aber nicht die vom zweiten Signal S2 erwartete Abhängigkeit (vom Eingangssignal SE) aufweist.

Wird bspw. während des laufenden Betriebs die Übertragung des zweiten Signals S2 an die Vergleichsschaltung 20 durch ein entsprechendes Steuersignal unterbrochen oder die Ableitung des zweiten Signals S2 gezielt gestört/modifiziert, kann dadurch überprüft werden, ob die Vergleichsschaltung 20 den Fehler erkennt bzw. das Ausgangssignal SA den künstlich erzeugten Fehler anzeigt. Wird der künstlich erzeugte Fehler nicht angezeigt, kann die Erzeugung des Fehlersignals bspw. durch eine Überprüfungsschaltung (nicht gezeigt) ausgelöst werden, um anzuzeigen, dass die Schaltung 10 nicht fehlerfrei funktioniert.

Fig. 3 zeigt eine mögliche Ausgestaltung der analogen Eingangsschaltung 14 des Schaltkreises 12. Die analoge Eingangsschaltung 14 umfasst einen ersten Widerstand 24a und einen zweiten Widerstand 24b, an denen eine das Eingangssignal SE repräsentierende Eingangsspannung abfällt. Die an den Widerständen 24a, 24b abfallenden Spannungen werden abgegriffen und jeweils einem Verstärker 26a, 26b zugeführt, der die abgegriffene Spannung verstärkt und das erste Signal S1 bzw. das zweite Signal S2 ausgibt. Durch das Verhältnis der Widerstände 24a, 24b (R1/R2) und das Verhältnis der Verstärkungsfaktoren (V1/V2) können dabei sowohl (annähernd) identische Signale S1, S2, als auch Signale S1, S2, die sich unterscheiden, erzeugt werden.

Bspw. können durch (annähernd) gleich große Widerstände 24a, 24b und (annähernd) gleich große Verstärkungsfaktoren (annähernd) identische Signale S1, S2 erzeugt werden. Ebenso können durch unterschiedlich große Widerstände 24a, 24b und entsprechend ungleich große Verstärkungsfaktoren (annähernd) identische Signale S1, S2 erzeugt werden (bspw. durch R1/R2=V2/V1). Unterscheiden sich die die Signale S1, S2 repräsentierenden Spannungen um einen bestimmten Faktor, kann dies ferner durch entsprechende Auslegung der Vergleichsschaltung 20 oder im Rahmen der Festlegung des Toleranzbereichs TOL berücksichtigt werden.

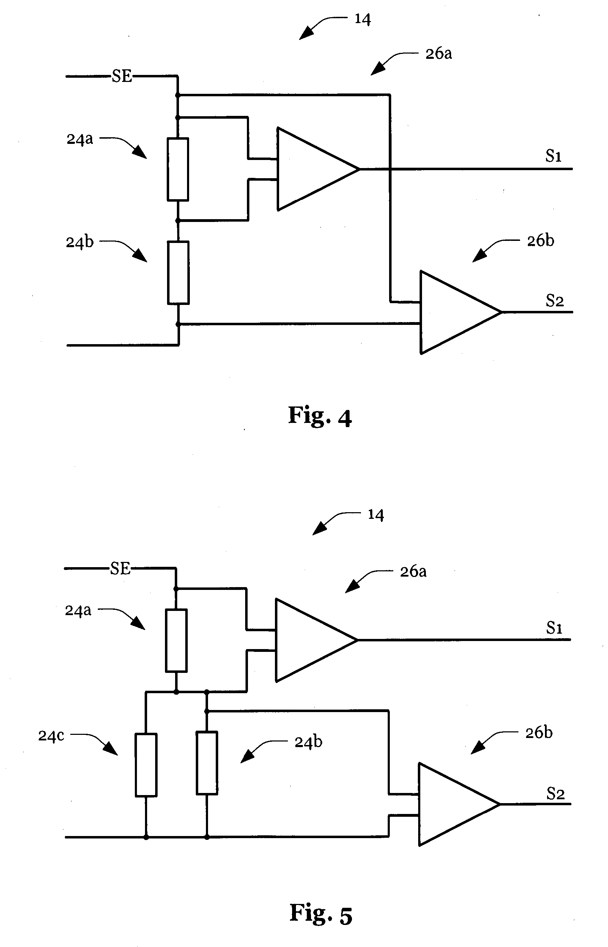

Fig. 4 zeigt eine weitere mögliche Ausgestaltung der analogen Eingangsschaltung 14 des Schaltkreises 12, welche sich von der in Fig. 3 gezeigten Ausgestaltung dadurch unterscheidet, dass neben der über den ersten Widerstand 24a abfallenden Spannung, die über beiden Widerstände 24a, 24b abfallende Eingangsspannung abgegriffen und jeweils einem Verstärker 26a, 26b zugeführt wird, der die abgegriffene Spannung verstärkt und das erste Signal S1 bzw. das zweite Signal S2 ausgibt. (Annähernd) identische Signale S1, S2 können dann durch eine entsprechende Dimensionierung der Verstärkungsfaktoren der Verstärker 26a, 26b erreicht werden wie bspw. V2/V1=(R1+R2)/R2. Sind die Widerstände 24a, 24b bspw. baugleich, können (annähernd) identische Signale S1, S2 dadurch erreicht werden, dass das zweite Signal S2 um einen Verstärkungsfaktor verstärkt wird, der halb so groß ist, wie der Verstärkungsfaktor des ersten Verstärkers 26a.

Fig. 5 zeigt eine weitere mögliche Ausgestaltung der analogen Eingangsschaltung 14 des Schaltkreises 12, welche sich von der in Fig. 3 gezeigten Ausgestaltung dadurch unterscheidet, dass ein dritter Widerstand 24c zum zweiten Widerstand 24b parallelgeschaltet ist. Dadurch können (annähernd) identische Signale S1, S2 auch dann erzeugt werden, wenn ungleich große Widerstände 24a, 24b und gleich große Verstärkungsfaktoren oder gleich große Widerstände 24a, 24b und ungleich große Verstärkungsfaktoren vorliegen. Zudem erzeugt der zweite parallelgeschaltete Widerstand 24b sicherheitstechnische Vorteile, weil die Widerstände 24a und 24b/c bspw. bei Überstrom unterschiedlich belastet werden und dadurch auf Grund des unterschiedlichen Verhaltens der Widerstände 24a, 24b, 24c bei Überstrom die Erzeugung des Fehlersignals bewirkt wird.

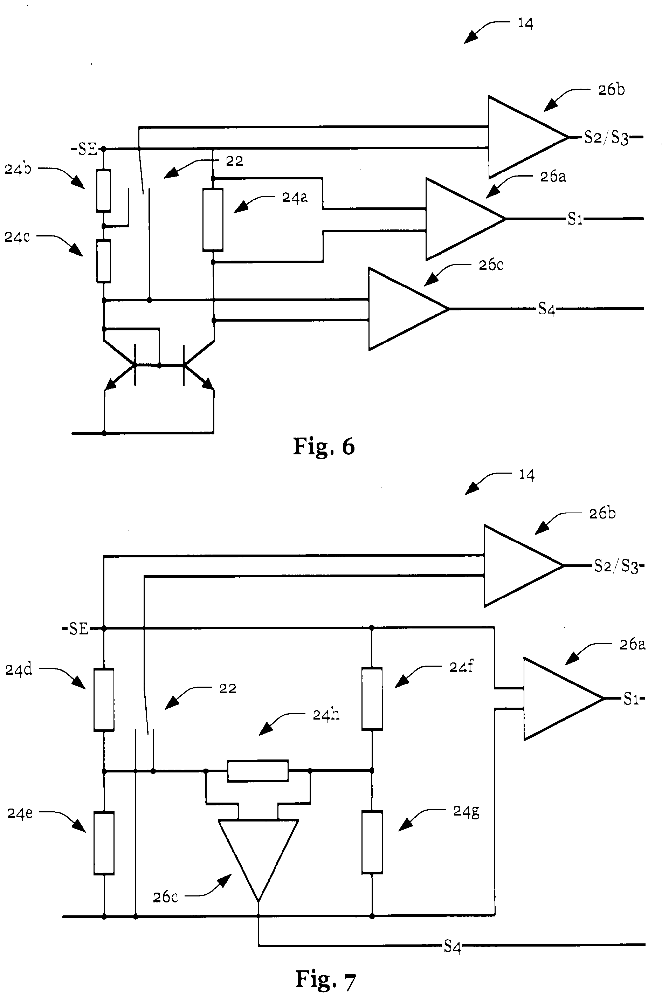

Fig. 6 zeigt eine weitere mögliche Ausgestaltung der analogen Eingangsschaltung 14 des in Fig. 1 gezeigten Schaltkreises 12, welche sich von der in Fig. 3 gezeigten Ausgestaltung dadurch unterscheidet, dass das erste Signal S1 und das zweite Signal S2 an Widerständen in parallelen Strompfaden abgegriffen werden, wobei die parallelen Strompfade mit einem Stromspiegel verbunden sind, so dass die durch die Strompfade fließenden Ströme in einem festen Verhältnis (bspw. 1:1) zueinander stehen. Ferner kann, wie in Fig. 6 gezeigt, ein viertes Signal S4 zur Erfassung von Unterschieden zwischen den Widerständen in den Strompfaden erzeugt werden. Liegt die das vierte Signal S4 repräsentierende Spannung außerhalb eines akzeptablen Bereichs, kann daraus auf eine Störung oder einen Fehler in den Widerständen 24a-24c bzw. in den Leitungen zwischen den Widerständen 24a-24c geschlossen werden.

Zudem umfasst die in Fig. 6 gezeigte analoge Eingangsschaltung 14 ein Schaltelement 22, durch das anstatt des zweiten Signals S2 ein drittes Signal S3 ausgegeben werden kann, welches zwar nicht unabhängig vom Eingangssignal SE ist, sich aber vom zweiten Signal S2 unterscheidet. So umfasst einer der parallelen Strompfade mehrere Widerstände, wobei das zweite Signal S2 und das dritte Signal S3 über eine unterschiedliche Anzahl an Widerständen abgegriffen werden. Dadurch unterscheidet sich die das dritte Signal S3 repräsentierende Spannung von der das zweite Signal S2 repräsentierenden Spannung um einen bestimmten Faktor (z.B. 0,5 oder 2).

Fig. 7 zeigt eine weitere mögliche Ausgestaltung der analogen Eingangsschaltung 14 des Schaltkreises 12, welche sich von der in Fig. 6 gezeigten Schaltung dadurch unterscheidet, dass die parallelen Strompfade in Form einer Brückenschaltung mit jeweils zwei gleich großen Widerständen 24d, 24f und 24e, 24g ausgebildet sind, wobei die über den im Brückenzweig angeordneten Widerstand 24h abfallende Spannung (nach einer optionalen Verstärkung durch den Verstärker 26) als viertes Signal S4 ausgegeben und die das vierte Signal S4 repräsentierende Spannung zur Erfassung von Unterschieden zwischen den Widerständen in den Strompfaden genutzt werden kann. Liegt die das vierte Signal S4 repräsentierende Spannung außerhalb eines akzeptablen Bereichs, kann daraus auf eine Störung oder einen Fehler in den Widerständen 24d-24g bzw. in den Leitungen zwischen den Widerständen 24d-24g geschlossen werden.

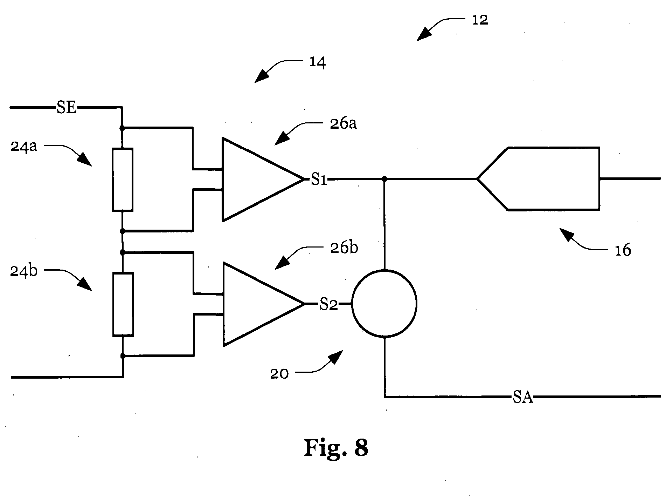

Fig. 8 zeigt eine mögliche Ausgestaltung des in Fig. 1 gezeigten Schaltkreises 12, welche die in Fig. 3 gezeigte Eingangsschaltung 14 umfasst. Dabei erzeugt die Vergleichsschaltung 20 bspw. ein Ausgangssignal SA, welches der Differenz DIFF zwischen der das erste Signal 1 repräsentierenden Spannung und der das zweite Signal repräsentierenden Spannung entspricht, oder, wie in Fig. 1a gezeigt, anzeigt, ob die Differenzspannung DIFF innerhalb oder außerhalb des Toleranzbereichs TOL liegt.

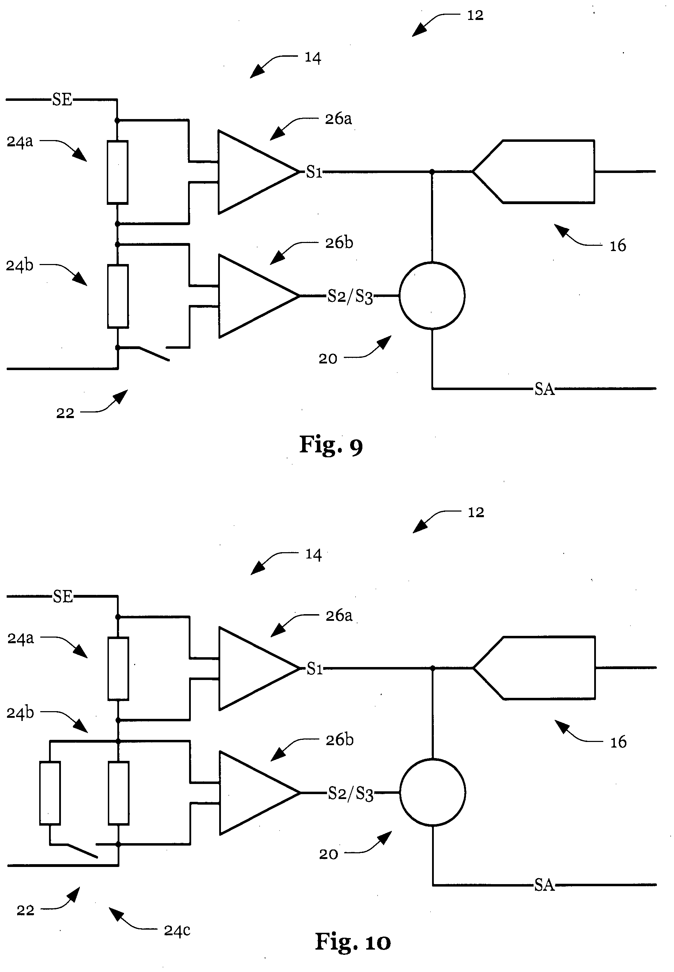

Fig. 9 zeigt eine mögliche Ausgestaltung des in Fig. 2 gezeigten Schaltkreises 12, welche die in Fig. 3 gezeigte Eingangsschaltung 14 umfasst. Dabei ist das Schaltelement 22 so in die Eingangsschaltung 14 integriert, dass bei geöffnetem Schaltelement 22 das zweite Signal S2 nicht mehr von der Eingangsspannung abgeleitet wird. Dadurch wird die bei geschlossenem Schaltelement 22 zwischen dem ersten Signal S1 und dem zweiten Signal S2 bestehende Abhängigkeit aufgehoben, wodurch bei hohen Eingangsspannungen entsprechend hohe Differenzspannungen DIFF auftreten und die Abweichung zwischen den abgeleiteten Signalen S1, S2 außerhalb des Toleranzbereichs TOL liegt.

Fig. 10 zeigt eine Modifikation des in Fig. 9 gezeigten Schaltkreises 12, wobei anstatt der Erzeugung eines vom Eingangssignal unabhängigen dritten Signals S3, das dritte Signal S3 durch eine gezielte Änderung de Ableitung des zweiten Signal S2 erzeugt wird, so dass das dritte Signal S3 zwar nicht unabhängig vom Eingangssignal SE ist, aber nicht die vom zweiten Signal S2 erwartete Abhängigkeit (vom Eingangssignal SE) aufweist. Wie in Fig. 10 gezeigt, wird durch Schließen des Schaltelements 22 (analog zur Ausgestaltung in Fig. 5) dem zweiten Widerstand 24b ein dritter Widerstand 24c parallelgeschaltet und dadurch die am zweiten Widerstand 24b abgegriffene Spannung geändert.

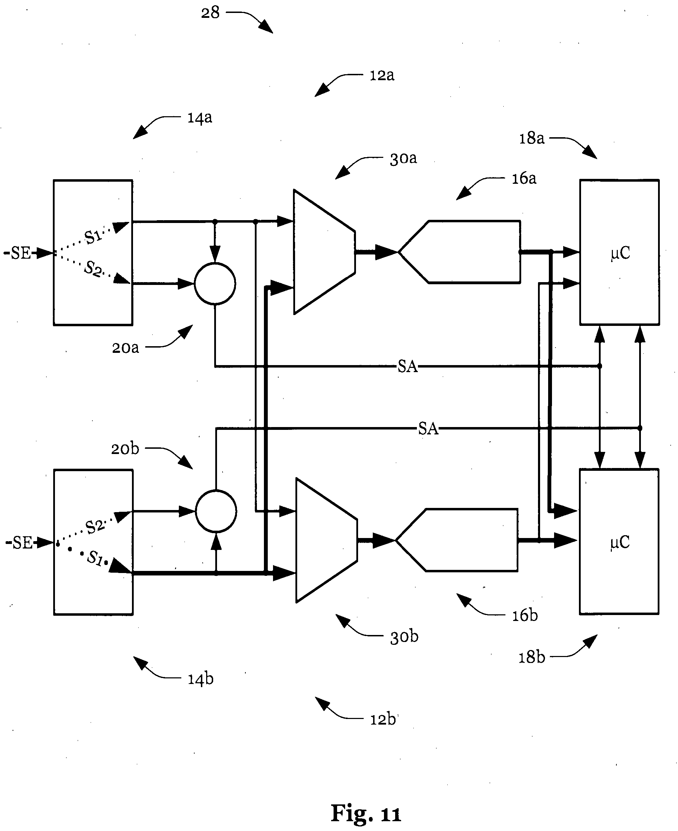

Fig. 11 zeigt ein System 28 mit zwei der in Fig. 1 gezeigten Schaltungen 10 zur Schaffung redundanter Übertragungskanäle, wobei in jeder der Schaltungen 10 dem A/D-Wandler 16a/16b eine zusätzliche Selektionsschaltung 30a/30b vorgeschaltet ist. Die Selektionsschaltungen 30a/30b empfangen eingangsseitig die ersten Signale S1 beider Schaltungen 10 und geben ausgangsseitig ein ausgewähltes der ersten Signale S1 in den jeweiligen A/D-Wandler 16a/16b ein. Durch Eingeben des gleichen ersten Signals S1 in beide A/D-Wandler 16a/16b können, wie in Fig. 10 durch die hervorgehobenen Signalpfade verdeutlicht, die A/D-Wandler 16a/16b über einen Abgleich der digitalisierten Signale überprüft werden.

Dazu sind beide A/D-Wandler 16a/16b ausgangsseitig mit beiden Mikrocontrollern 18a/18b verbunden, so dass die Mikrocontroller 18a/18b die ausgegebenen digitalisierten Daten beider A/D-Wandler 16a/16b einlesen können. Die eingelesenen digitalisierten Daten können dann dahingehend überprüft werden, ob eine Abweichung der digitalisierten Daten voneinander innerhalb eines Toleranzbereichs liegt.

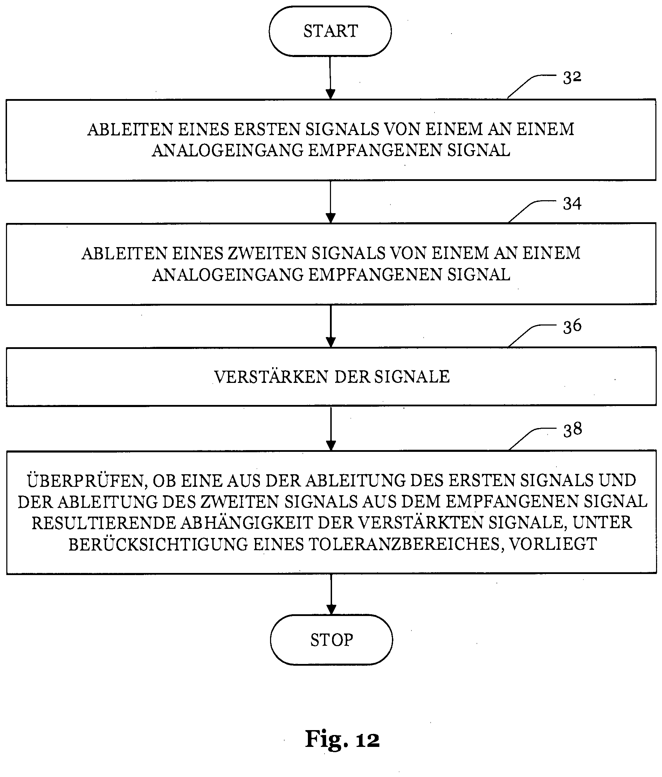

Fig. 12 zeigt ein Flussdiagramm eines Prozesses zum Digitalisieren eines an einem Analogeingang empfangenen Signals. Der Prozess beginnt mit den Schritten 32, 34 des Ableitens des ersten Signals S1 von dem am Analogeingang empfangenen Signal SE und des Ableitens des zweiten Signals S2 von dem am Analogeingang empfangenen Signal SE, sowie dem Schritt des Verstärkens des ersten Signals S1 und dem Verstärken des zweiten Signals S2. Der Prozess wird dann mit dem Schritt 38 des Überprüfens, ob die aus der Ableitung des ersten Signals S1 und der Ableitung des zweiten Signals S2 aus dem empfangenen Signal SE resultierende erwartete Abhängigkeit der verstärkten Signale, unter Berücksichtigung des Toleranzbereichs TOL, vorliegt. Wenn die Abhängigkeit der verstärkten Signale nicht vorliegt, kann, wie im Vorhergehenden beschrieben, ein Fehlersignal erzeugt werden.

Dabei versteht es sich, dass alle Merkmale der im Vorhergehenden beschriebenen Schaltkreise auch Merkmale bevorzugter Ausführungsformen des Prozesses sein können, welches sich auf die Verwendung des Schaltkreises 12 zur Überprüfung einer analogen Eingangsschaltung 14 eines A/D-Wandlers 16 bezieht, wobei der Schaltkreis 12 die analoge Eingangsschaltung 14 und eine Vergleichsschaltung 20 umfasst und die analoge Eingangsschaltung 14 eingerichtet ist, aus dem analogen Eingangssignal SE der analogen Eingangsschaltung 14 ein erstes abgeleitetes Signal S1 und ein zweites abgeleitetes Signal S2 zu erzeugen.

Wie im Vorhergehenden beschrieben, sind das erste abgeleitete Signal S1 und das zweite abgeleitete Signal S2 Eingangssignale für die Vergleichsschaltung 20; aber nur das erste abgeleitete Signal S1 ist ein Eingangssignal für den A/D-Wandler 16. Die Vergleichsschaltung 20 kann dann überprüfen, ob eine Abweichung der abgeleiteten Signale S1, S2 voneinander innerhalb des Toleranzbereichs TOL liegt und ein von der Überprüfung abhängiges Ausgangssignal SA ausgeben, das weiter auswertbar ist (bspw. durch einen Mikrocontroller 18 oder eine übergeordnete Steuerung).

### BEZUGSZEICHENLISTE

- 10: Schaltung
- 12: Schaltkreis
- 14: Eingangsschaltung
- 16: A/D-Wandler
- 18: Mikrocontroller
- 20: Vergleichsschaltung
- 22: Schaltelement
- 24: Widerstand
- 26: Verstärker
- 28: System
- 30: Selektionsschaltung
- 32-38: Prozessschritte
- DIFF: Differenzspannung
- S1: erstes Signal
- S2: zweites Signal
- S3: drittes Signal
- S4: viertes Signal
- SE: Eingangssignal
- SA: Ausgangssignal
- TOL: Toleranzbereich

## Patentansprüche

1. Schaltkreis (12) zur Überprüfung einer analogen Eingangsschaltung (14) eines A/D-Wandlers (16), umfassend:
die analoge Eingangsschaltung (14); und
eine Vergleichsschaltung (20);
wobei
die analoge Eingangsschaltung (14) eingerichtet ist, aus einem analogen Eingangssignal (SE) der analogen Eingangsschaltung (14) ein erstes abgeleitetes Signal (S1) und ein zweites abgeleitetes Signal (S2) zu erzeugen;
nur das erste abgeleitete Signal (S1) ein Eingangssignal für den A/D-Wandler (16) ist, welcher das erste abgeleitete Signal (S1) digitalisiert;
das erste abgeleitete Signal (S1) und das zweite abgeleitete Signal (S2) Eingangssignale für die Vergleichsschaltung (20) sind;
die Vergleichsschaltung (20) eingerichtet ist, zu überprüfen, ob eine Abweichung der abgeleiteten Signale (S1, S2) voneinander innerhalb eines Toleranzbereichs (TOL) liegt und ein von der Überprüfung abhängiges Ausgangssignal (SA) auszugeben, das weiter auswertbar ist.

2. Schaltkreis (12) nach Anspruch 1, wobei der Schaltkreis (12) ein Schaltelement (22) aufweist, wobei durch Schließen oder Öffnen des Schaltelements (22) das zweite abgeleitete Signal (S2) gezielt verändert oder abgeschaltet werden kann, um einen definierten Fehlerzustand zu erzeugen.

3. Schaltkreis (12) nach Anspruch 1 oder 2, wobei die Vergleichsschaltung (20) eingerichtet ist, aus dem ersten abgeleiteten Signal (S1) und dem zweiten abgeleiteten Signal (S2) ein Differenzsignal (DIFF) abzuleiten und der Toleranzbereich (TOL) einen Wertebereich für das Differenzsignal (DIFF) vorgibt.

4. Schaltkreis (12) nach einem der Ansprüche 1 bis 3, wobei
die analoge Eingangsschaltung (14) eingerichtet ist, das erste abgeleitete Signal (S1) aus einem Spannungsabfall an einem ersten Widerstand (24a) abzuleiten; und
das zweite abgeleitete Signal (S2) aus einem Spannungsabfall an einem zweiten Widerstand (24b) abzuleiten;
wobei der erste Widerstand (24a) und der zweite Widerstand (24b) in Reihe an einem Analogeingang der Eingangsschaltung (14) angeschlossen sind.

5. Schaltkreis (12) nach einem der Ansprüche 1 bis 4, wobei
die analoge Eingangsschaltung (14) einen ersten Verstärker (26a) und einen zweiten Verstärker (26b) umfasst;
das erste abgeleitete Signal (S1) ein Ausgangssignal des ersten Verstärkers (26a) ist; und
das zweite abgeleitete Signal (S2) ein Ausgangssignal des zweiten Verstärkers (26b) ist.

6. System (28). umfassend:
einen ersten Schaltkreis (12a) nach einem der Ansprüche 1 bis 5; und
einen zweiten Schaltkreis (12b) nach einem der Ansprüche 1 bis 5; wobei der erste Schaltkreis (12a) eine erste Selektionsschaltung (30a) umfasst und der zweite Schaltkreis (12b) eine zweite Selektionsschaltung (30b) umfasst;
wobei die erste Selektionsschaltung (30a) eingerichtet ist, das erste abgeleitete Signal (S1) des ersten Schaltkreises (12a) oder das erste abgeleitete Signal (S1) des zweiten Schaltkreises (12b) an den A/D-Wandler (16a) des ersten Schaltkreises (12a) zu übertragen;
wobei die zweite Selektionsschaltung (30b) eingerichtet ist, das erste abgeleitete Signal (S1) des ersten Schaltkreises (12a) oder das erste abgeleitete Signal (S1) des zweiten Schaltkreises (12b) an den A/D-Wandler (16b) des zweiten Schaltkreises (12b) zu übertragen;
wobei das System (28) ferner eingerichtet ist, zu überprüfen, ob die durch die A/D-Wandler (16a, 16b) digitalisierten Signale identisch sind oder eine Abweichung der digitalisierten Signale voneinander innerhalb eines Akzeptanzbereichs liegt, wenn die Selektionsschaltungen (30a, 30b) das erste abgeleitete Signal (S1) des ersten Schaltkreises (12a) bzw. das erste abgeleitete Signal (S1) des zweiten Schaltkreises (12b) an die A/D-Wandler (16a, 16b) übertragen.

7. Verfahren zum Digitalisieren eines an einem Analogeingang empfangenen Signals (SE), umfassend:
Ableiten (32) eines ersten Signals (S1) von dem am Analogeingang empfangenen Signal (SE);
Ableiten (34) eines zweiten Signals (S2) von dem am Analogeingang empfangenen Signal (SE);
Verstärken (36) des ersten Signals (S1);
Verstärken (36) des zweiten Signals (S2);
Digitalisieren des verstärkten ersten Signals;
Überprüfen (38), ob eine aus der Ableitung des ersten Signals (S1) und der Ableitung des zweiten Signals (S2) aus dem empfangenen Signal (SE) resultierende erwartete Abhängigkeit der verstärkten Signale, unter Berücksichtigung eines Toleranzbereichs (TOL), vorliegt; und
wenn die Abhängigkeit der verstärkten Signale nicht vorliegt, Erzeugen eines Fehlersignals.

8. Verfahren nach Anspruch 7, ferner umfassend:
Verstärken eines dritten Signals (S3), welches von dem am Analogeingang empfangenen Signal (SE) unabhängig ist oder mittels einer gezielten Modifikation der Ableitung des zweiten Signals (S2) erzeugt wird; und
Überprüfen, ob eine Abweichung zwischen dem verstärkten ersten Signal (S1) und dem verstärkten dritten Signal (S3) außerhalb des Toleranzbereichs (TOL) liegt.

9. Verfahren nach Anspruch 8, ferner umfassend:
Erzeugen des Fehlersignals, wenn die Abweichung zwischen dem verstärkten ersten Signal (S1) und dem verstärkten dritten Signal (S3) innerhalb des Toleranzbereichs (TOL) liegt.

10. Verfahren nach einem der Ansprüche 7 bis 9, ferner umfassend:
Ableiten eines Differenzsignals (DIFF) aus dem verstärkten ersten Signal (S1) und dem verstärkten zweiten Signal (S2), wobei der Toleranzbereich (TOL) einen Wertebereich für das Differenzsignal (DIFF) vorgibt.

## Claims

1. Switching circuit (12) for checking an analog input circuit (14) of an A/D converter (16), comprising:
the analog input circuit (14); and
a comparator circuit (20);
wherein
the analog input circuit (14) is configured to generate a first derived signal (S1) and a second derived signal (S2) from an analog input signal (SE) of the analog input circuit (14);
only the first derived signal (S1) is an input signal for the A/D converter (16), which digitizes the first derived signal (S1);
the first derived signal (S1) and the second derived signal (S2) are input signals for the comparator circuit (20);
the comparator circuit (20) is configured to check whether a deviation of the derived signals (S1, S2) from each other lies within a tolerance range (TOL) and to output an output signal (SA) which is dependent on the check and which can be further evaluated.

2. Switching circuit (12) according to claim 1, wherein the switching circuit (12) has a switching element (22), wherein the second derived signal (S2) can be changed or deactivated in a targeted manner by closing or opening the switching element (22) in order to generate a defined error state.

3. Switching circuit (12) according to claim 1 or 2, wherein the comparator circuit (20) is configured to derive a difference signal (DIFF) from the first derived signal (S1) and the second derived signal (S2), and the tolerance range (TOL) specifies a value range for the difference signal (DIFF).

4. Switching circuit (12) according to any of claims 1 to 3, wherein
the analog input circuit (14) is configured to derive the first derived signal (S1) from a voltage drop at a first resistor (24a); and
to derive the second derived signal (S2) from a voltage drop at a second resistor (24b);
wherein the first resistor (24a) and the second resistor (24b) are connected in series to an analog input of the input circuit (14).

5. Switching circuit (12) according to any of claims 1 to 4, wherein
the analog input circuit (14) comprises a first amplifier (26a) and a second amplifier (26b);
the first derived signal (S1) is an output signal of the first amplifier (26a); and
the second derived signal (S2) is an output signal of the second amplifier (26b).

6. System (28), comprising:
a first switching circuit (12a) according to any of claims 1 to 5; and
a second switching circuit (12b) according to any of claims 1 to 5; wherein the first switching circuit (12a) comprises a first selection circuit (30a) and the second switching circuit (12b) comprises a second selection circuit (30b);
wherein the first selection circuit (30a) is configured to transmit the first derived signal (S1) of the first switching circuit (12a) or the first derived signal (S1) of the second switching circuit (12b) to the A/D converter (16a) of the first switching circuit (12a);
wherein the second selection circuit (30b) is configured to transmit the first derived signal (S1) of the first switching circuit (12a) or the first derived signal (S1) of the second switching circuit (12b) to the A/D converter (16b) of the second switching circuit (12b);
wherein the system (28) is further configured to check whether the signals digitized by the A/D converters (16a, 16b) are identical or whether a deviation of the digitized signals from each other lies within an acceptance range when the selection circuits (30a, 30b) transmit the first derived signal (S1) of the first switching circuit (12a) or the first derived signal (S1) of the second switching circuit (12b) to the A/D converters (16a, 16b).

7. Method for digitizing a signal (SE) received at an analog input, the method comprising:
deriving (32) a first signal (S1) from the signal (SE) received at the analog input;
deriving (34) a second signal (S2) from the signal (SE) received at the analog input;
amplifying (36) the first signal (S1);
amplifying (36) the second signal (S2);
digitizing the amplified first signal;
checking (38) whether an expected dependency of the amplified signals resulting from the derivation of the first signal (S1) and the derivation of the second signal (S2) from the received signal (SE) is present, taking into account a tolerance range (TOL); and
generating an error signal if the dependency of the amplified signals is not present.

8. Method according to claim 7, further comprising:
amplifying a third signal (S3) which is independent of the signal (SE) received at the analog input or is generated by means of a targeted modification of the derivation of the second signal (S2); and
checking whether a deviation between the amplified first signal (S1) and the amplified third signal (S3) lies outside the tolerance range (TOL).

9. Method according to claim 8, further comprising:
generating the error signal if the deviation between the amplified first signal (S1) and the amplified third signal (S3) lies within the tolerance range (TOL).

10. Method according to any of claims 7 to 9, further comprising:
deriving a difference signal (DIFF) from the amplified first signal (S1) and the amplified second signal (S2), wherein the tolerance range (TOL) specifies a value range for the difference signal (DIFF).

## Revendications

1. Circuit de commutation (12) pour vérifier un circuit d'entrée analogique (14) d'un convertisseur A/N (16), comprenant :
le circuit d'entrée analogique (14) ; et
un circuit de comparaison (20) ;
dans lequel
le circuit d'entrée analogique (14) est configuré pour générer un premier signal dérivé (S1) et un deuxième signal dérivé (S2) à partir d'un signal d'entrée analogique (SE) du circuit d'entrée analogique (14) ;
seul le premier signal dérivé (S1) est un signal d'entrée pour le convertisseur A/N (16), lequel numérise le premier signal dérivé (S1) ;
le premier signal dérivé (S1) et le deuxième signal dérivé (S2) sont des signaux d'entrée pour le circuit de comparaison (20) ;
le circuit de comparaison (20) est configuré pour vérifier si un écart entre les signaux dérivés (S1, S2) se situe au sein d'une plage de tolérance (TOL) et pour émettre un signal de sortie (SA) dépendant de la vérification, qui peut en outre être évalué.

2. Circuit de commutation (12) selon la revendication 1, dans lequel le circuit de commutation (12) présente un élément de commutation (22), dans lequel par l'intermédiaire de la fermeture ou de l'ouverture de l'élément de commutation (22), le deuxième signal dérivé (S2) peut être changé ou coupé de manière ciblée pour générer un état d'erreur défini.

3. Circuit de commutation (12) selon la revendication 1 ou 2, dans lequel le circuit de comparaison (20) est configuré pour dériver un signal de différence (DIFF) à partir du premier signal dérivé (S1) et du deuxième signal dérivé (S2), et la plage de tolérance (TOL) prescrit une plage de valeurs pour le signal de différence (DIFF).

4. Circuit de commutation (12) selon l'une quelconque des revendications 1 à 3, dans lequel
le circuit d'entrée analogique (14) est configuré pour dériver le premier signal dérivé (S1) à partir d'une chute de tension au niveau d'une première résistance (24a) ; et
dériver le deuxième signal dérivé (S2) à partir d'une chute de tension au niveau d'une deuxième résistance (24b) ;
dans lequel la première résistance (24a) et la deuxième résistance (24b) sont connectées en série à une entrée analogique du circuit d'entrée (14).

5. Circuit de commutation (12) selon l'une quelconque des revendications 1 à 4, dans lequel
le circuit d'entrée analogique (14) comprend un premier amplificateur (26a) et un deuxième amplificateur (26b) ;
le premier signal dérivé (S1) est un signal de sortie du premier amplificateur (26a) ; et
le deuxième signal dérivé (S2) est un signal de sortie du deuxième amplificateur (26b).

6. Système (28) comprenant :
un premier circuit de commutation (12a) selon l'une quelconque des revendications 1 à 5 ; et
un deuxième circuit de commutation (12b) selon l'une quelconque des revendications 1 à 5 ; dans lequel le premier circuit de commutation (12a) comprend un premier circuit de sélection (30a) et le deuxième circuit de commutation (12b) comprend un deuxième circuit de sélection (30b) ;
dans lequel le premier circuit de sélection (30a) est configuré pour transmettre le premier signal dérivé (S1) du premier circuit de commutation (12a) ou le premier signal dérivé (S1) du deuxième circuit de commutation (12b) au convertisseur A/N (16a) du premier circuit de commutation (12a) ;
dans lequel le deuxième circuit de sélection (30b) est configuré pour transmettre le premier signal dérivé (S1) du premier circuit de commutation (12a) ou le premier signal dérivé (S1) du deuxième circuit de commutation (12b) au convertisseur A/N (16b) du deuxième circuit de commutation (12b) ;
dans lequel le système (28) est en outre configuré pour vérifier si les signaux numérisés par les convertisseurs A/N (16a, 16b) sont identiques ou si un écart entre les signaux numérisés se situe au sein d'une plage d'acceptation lorsque les circuits de sélection (30a, 30b) transmettent le premier signal dérivé (S1) du premier circuit de commutation (12a) ou le premier signal dérivé (S1) du deuxième circuit (12b) aux convertisseurs A/N (16a, 16b).

7. Procédé de numérisation d'un signal reçu (SE) au niveau d'une entrée analogique, compenant :
la dérivation (32) d'un premier signal (S1) à partir du signal reçu (SE) au niveau de l'entrée analogique ;
la dérivation (34) un deuxième signal (S2) à partir du signal reçu (SE) au niveau de l'entrée analogique ;
l'amplification (36) du premier signal (S1) ;
l'amplification (36) du deuxième signal (S2) ;
la numérisation du premier signal amplifié ;
la vérification (38) pour déterminer si une dépendance attendue des signaux amplifiés résultant de la dérivation du premier signal (S1) et de la dérivation du deuxième signal (S2) à partir du signal reçu (SE) est présente en tenant compte d'une plage de tolérance (TOL) ; et
si la dépendance des signaux amplifiés n'est pas présente, la génération d'un signal d'erreur.

8. Procédé selon la revendication 7, comprenant en outre :
l'amplification d'un troisième signal (S3) qui est indépendant du signal reçu (SE) au niveau de l'entrée analogique ou qui est généré au moyen d'une modification ciblée de la dérivation du deuxième signal (S2) ; et
la vérification pour déterminer si un écart entre le premier signal amplifié (S1) et le troisième signal amplifié (S3) se situe hors de la plage de tolérance (TOL).

9. Procédé selon la revendication 8, comprenant en outre :
la génération du signal d'erreur si l'écart entre le premier signal amplifié (S1) et le troisième signal amplifié (S3) se situe dans la plage de tolérance (TOL).

10. Procédé selon l'une quelconque des revendications 7 à 9, comprenant en outre :
la dérivation d'un signal de différence (DIFF) à partir du premier signal amplifié (S1) et du deuxième signal amplifié (S2), dans lequel la plage de tolérance (TOL) définit une plage de valeurs pour le signal de différence (DIFF).
